# EUROPEAN PATENT SPECIFICATION

(11) **EP 4 071 883 B1**
(45) Date of publication and mention of the grant of the patent: **06.05.2026**
(21) Application number: 21856134.8
(22) Date of filing: 05.08.2021
(51) Int. Cl.: H01M 10/42, H01M 10/44, G01R 31/392

(54) **DEGRADED CELL MANUFACTURING METHOD AND DEGRADED CELL EVALUATION METHOD**
VERFAHREN ZUR HERSTELLUNG VON DEGRADIERTEN ZELLEN UND VERFAHREN ZUR BEWERTUNG VON DEGRADIERTEN ZELLEN
PROCÉDÉ DE FABRICATION DE CELLULE DÉGRADÉE ET PROCÉDÉ D'ÉVALUATION DE CELLULE DÉGRADÉE

(30) Priority: 12.08.2020 KR 20200100842
(43) Date of publication of application: 12.10.2022
(73) Proprietor: LG Energy Solution, Ltd., Seoul 07335 (KR)
(72) Inventor: PARK, Su Han, Daejeon 34122 (KR); LEE, Jong Hwa, Daejeon 34122 (KR); KIM, Ki Woong, Daejeon 34122 (KR); CHUNG, Dae Sik, Daejeon 34122 (KR)
(74) Representative: Goddar, Heinz J.
(86) International application number: PCT/KR2021/010339
(87) International publication number: WO 2022/035128

(56) References cited:
- JP-A- 2015 228 325
- JP-A- 2018 156 739
- JP-A- 2018 156 739
- JP-A- 2019 192 553
- JP-A- 2019 192 553
- KR-A- 20160 072 070
- KR-A- 20170 009 995
- US-A1- 2019 267 671

## Description

### [Technical Field]

The present invention relates to a method for manufacturing a degenerate cell and a method for evaluating a degenerate cell including the same.

### [Background Art]

US 2019/0267671 A1 relates to the field of battery technology, and more specifically relates to an electrolyte and a secondary lithium battery. JP 2019 192553 A relates to a Li deposition evaluation method for evaluating the deposition of metallic Li that occurs on the surface of a negative electrode plate of a lithium ion secondary battery.
JP 2018 156739 A relates to a battery safety evaluation device, a battery control device, a battery safety evaluation method, a program, a control circuit, and a power storage system.

Recently, secondary batteries capable of charging and discharging have been widely used as energy sources of wireless mobile devices. In addition, the secondary battery has attracted attention as an energy source of an electric vehicle, a hybrid electric vehicle, etc., which are proposed as a solution for air pollution of existing gasoline vehicles and diesel vehicles using fossil fuel. Therefore, the types of applications using the secondary battery are currently much diversified due to the advantages of the secondary battery, and it is expected that the secondary battery will be applied to many fields and products in the future.

Such secondary batteries may be classified into lithium ion batteries, lithium ion polymer batteries, lithium polymer batteries, etc., depending on the composition of the electrode and the electrolyte, and among them, the amount of use of lithium-ion polymer batteries that are less likely to leak electrolyte and are easy to manufacture is on the increase. In general, secondary batteries are classified into cylindrical batteries and prismatic batteries in which an electrode assembly is embedded in a cylindrical or rectangular metal can, depending on the shape of a battery case, and pouch-type batteries in which the electrode assembly is embedded in a pouch-type case of an aluminum laminate sheet. The electrode assembly built into the battery case is composed of a positive electrode, a negative electrode, and a separator interposed between the positive electrode and the negative electrode, and is a power generating element capable of charging and discharging. The electrode assembly is classified into a jelly-roll type wound with a separator interposed between the positive electrode and the negative electrode which are long sheet-shaped and are coated with active materials, and a stack type in which a plurality of positive electrodes and negative electrodes of a predetermined size are sequentially stacked while a separator is interposed therebetween.

Such a secondary battery may be used as one cell unit, a module unit generated by connection of a plurality of cells, or a pack unit generated by connection of a plurality of modules.

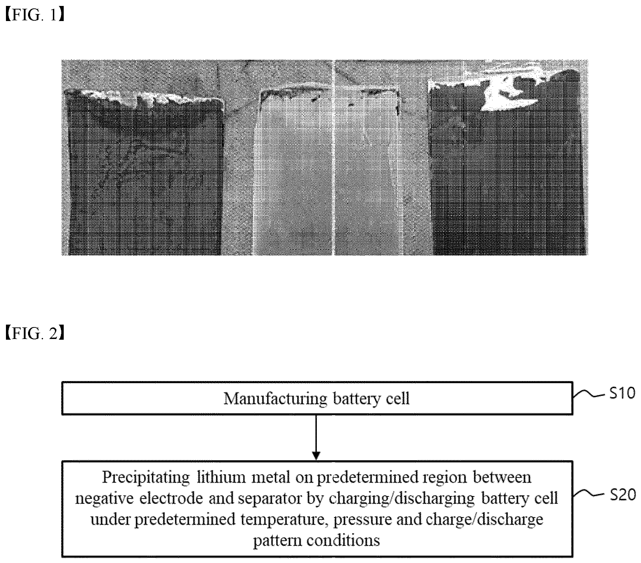

FIG. 1 is a photograph showing a precipitated lithium metal when a degeneration phenomenon occurs in a battery cell.

As shown in FIG. 1, if charge/discharge is repeated by the repeated use of a secondary battery, lithium is precipitated on the negative electrode, and accordingly, performance deterioration of the battery, such as voltage and capacity drop, occurs. In particular, when the battery is used in module and pack units, a difference occurs in the degeneration level between batteries according to the repetition of charge/discharge.

Hence, it is necessary to secure the degeneration behavior according to the charge/discharge of the actual cell, and analyze the module or pack unit behavior, not one battery cell behavior.

In this regard, Korean Patent No. 10-1293635 discloses an apparatus and method for managing a battery pack reflecting a degeneration degree of a secondary battery cell, capable of minimizing performance deterioration of the battery pack and allowing an electric vehicle having a battery pack mounted thereon to be more safely operated by more effectively generating and controlling various parameters showing characteristics of the battery pack by effectively reflecting the degeneration status of the secondary battery cell, and a battery pack including the method.

In addition, the Korean Patent Publication No. 10-2016-0136045 discloses a cell fabrication kit capable of manufacturing an electrode symmetry cell for degeneration analysis of the cell.

However, in order to determine the degenerated state, the cell was generally degenerated by repetition of the charge/discharge of the battery like the actual use of the battery, and it was difficult to measure the degenerated form of the battery according to the specific use conditions of the battery, for example, lithium precipitation pattern. Further, since the charge/discharge should be repeated until degeneration of the battery, it takes long time in measurement.

Hence, there is a need for a technology capable of recognizing a degeneration form of a battery according to charge/discharge conditions of the battery.

### [Disclosure]

### [Technical Problem]

The present invention is believed to solve at least some of the above problems. For example, an aspect of the present invention provides a degenerate cell manufacturing method capable of patterning lithium precipitation according to charge/discharge conditions, and accordingly evaluating the behavior of the degenerate cell by precipitating lithium metal on a desired region of a negative electrode, and a degenerate cell evaluation method including the degenerate cell manufacturing method.

### [Technical Solution]

A method for manufacturing a degenerate cell according to the present invention includes: preparing a battery cell which has a structure where an electrode assembly, which is generated by lamination of a negative electrode, a positive electrode, and a separator, is accommodated in a battery case, and an electrode lead is drawn out to an outside of the battery case; and precipitating lithium metal on a predetermined region between the negative electrode and the separator by performing charge and discharge under predetermined temperature, pressure and charge and discharge pattern conditions.

In a specific example, an initial state of charge (SOC) of the battery cell corresponds to 20 to 50%.

In one example, the charge and discharge is performed under a temperature in a range of -10 to 0°C.

According to the present disclosure, the charge and discharge are performed under a pressure in a range of 11,77 to 19,61 MPa [120 to 200 kgf/cm].

At this time, the pressure may be applied to an edge portion of the battery cell from which the electrode lead is drawn out.

Further, the pressure may be applied to a central portion of the battery cell.

In the present disclosure, the charge and discharge pattern includes constant current (CC)-charging the battery cell until reaching a predetermined voltage, constant voltage (CV)-charging the battery cell having reached the predetermined voltage until reaching a predetermined cutoff current, and constant current (CC)-discharging the CV-charged battery cell.

At this time, the CC-charging and the CC-discharging may be performed at a C-rate in a range of 0.5 to 1.5C.

In a specific example, a charge and discharge according to the charge and discharge pattern may be performed two or more times.

Further, the present invention provides a method for evaluating a degenerate cell, and the method includes: manufacturing a degenerate cell according to the method for manufacturing a degenerate cell described above; and determining: whether lithium metal has been precipitated in the degenerate cell; a precipitated region of the lithium metal; and a precipitation amount of the lithium metal.

In a specific example, the determining of: whether lithium metal has been precipitated in the degenerate cell; the precipitated region of the lithium metal; and the precipitation amount of the lithium metal includes building a database using information on whether lithium metal has been precipitated in the degenerate cell, the precipitated region of the lithium metal, and the precipitation amount of the lithium metal according to the temperature, pressure, and charge and discharge pattern.

Further, the method for evaluating a degenerate cell according to an embodiment of the present invention may further include performing a safety test for the degenerate cell.

At this time, the safety test may be performed after the degenerate cell is charged to show a predetermined state of charge (SOC).

Further, the method for evaluating the degenerate cell according to another embodiment of the present invention further includes preparing a module by connecting the degenerate cells and normal cells, where degeneration has not occurred, in series or in parallel, and performing a safety test for the module.

At this time, the safety test may be performed after the degenerate cell is charged to show a predetermined state of charge (SOC).

### [Advantageous Effects]

According to the degenerate cell manufacturing method and degenerate cell evaluation method of the present invention, lithium precipitation according to charge/discharge conditions can be patterned, and accordingly, lithium metal may be precipitated on a desired portion of the negative electrode, to thereby evaluate the behavior of the degenerate cell.

Further, according to the present invention, a degenerate cell can be manufactured by only a small number of times of repetition of charge/discharge.

Further, according to the present invention, it is possible to evaluate the influence of a degenerate cell on a battery module or pack by simulating a battery module or pack by connecting the degenerate cell with a normal cell.

### [Brief Description of the Drawings]

FIG. 1 is a photograph showing a precipitated lithium metal when a degeneration phenomenon occurs in a battery cell.
FIG. 2 is a flowchart illustrating the order of the degenerate cell manufacturing method according to the present invention.
FIG. 3 is a schematic diagram illustrating a shape of a jig for pressing a battery cell in a degenerate cell manufacturing method according to an embodiment of the present invention.
FIG. 4 is a schematic diagram illustrating a shape of a jig for pressing a battery cell in a degenerate cell manufacturing method according to another embodiment of the present invention.
FIG. 5 is a flowchart showing the procedure of a degenerate cell evaluation method according to an embodiment of the present invention.
FIG. 6 is a flowchart showing the procedure of a degenerate cell evaluation method according to another embodiment of the present invention.
FIGS. 7 to 10 are photographs showing whether lithium metal has been precipitated in a negative electrode in examples and comparative examples.

### [Detailed Description of the Preferred Embodiments]

Hereinafter, the present invention will be described in detail with reference to the drawings. The terms and words used in the present specification and claims should not be construed as limited to ordinary or dictionary terms and the inventor may properly define the concept of the terms in order to best describe its invention. The terms and words should be construed as meaning and concept consistent with the technical idea of the present invention.

In this application, it should be understood that terms such as "include" or "have" are intended to indicate that there is a feature, number, step, operation, component, part, or a combination thereof described on the specification, and they do not exclude in advance the possibility of the presence or addition of one or more other features or numbers, steps, operations, components, parts or combinations thereof. Also, when a portion such as a layer, a film, an area, a plate, etc. is referred to as being "on" another portion, this includes not only the case where the portion is "directly on" the another portion but also the case where further another portion is interposed therebetween. On the other hand, when a portion such as a layer, a film, an area, a plate, etc. is referred to as being "under" another portion, this includes not only the case where the portion is "directly under" the another portion but also the case where further another portion is interposed therebetween. In addition, to be disposed "on" in the present application may include the case disposed at the bottom as well as the top.

Hereinafter, the present invention will be described in detail with reference to the drawings.

FIG. 2 is a flowchart illustrating the order of the degenerate cell manufacturing method according to the present invention.

Referring to FIG. 2, a method for manufacturing a degenerate cell according to the present invention includes: preparing a battery cell which has a structure where an electrode assembly, which is generated by lamination of a negative electrode, a positive electrode, and a separator, is accommodated in a battery case, and an electrode lead is drawn out to an outside of the battery case (S10); and precipitating lithium metal on a predetermined region between the negative electrode and the separator by performing charge and discharge under predetermined temperature, pressure and charge and discharge pattern conditions (S20).

As described above, in the past, there was no way to check the lithium metal precipitation pattern in a degenerate cell. Even if the performance of the degenerate cell is evaluated, degenerating a cell by repetition of charge/discharge of a battery was a general method, and in this case, it took a long time due to the repetitive charge/discharge of the battery cell, and lithium was not precipitated on desired portions.

According to the degenerate cell manufacturing method of the present invention, lithium precipitation according to charge/discharge conditions can be patterned, and accordingly, lithium metal may be precipitated on a desired portion of the negative electrode, to thereby evaluate the behavior of the degenerate cell. As such, it is possible to manufacture a safety-enhanced cell through a short circuit evaluation, etc. for a specific region of a negative electrode.

Further, according to the present invention, a degenerate cell can be manufactured by only a small number of times of repetition of charge/discharge.

Hereinafter, a method for manufacturing a degenerate cell according to the present invention will be described in detail.

In order to manufacture a degenerate cell according to the present invention, a battery cell is first prepared. Here, the battery cell refers to a battery cell having normal performance before degeneration. In addition, the degenerate cell refers to a battery cell in a state in which lithium metal has been precipitated in a negative electrode in the battery cell.

Specifically, the battery cell has a structure where an electrode assembly, which is generated by lamination of a negative electrode, a positive electrode, and a separator, is accommodated in a battery case, and an electrode lead is drawn out to an outside of the battery case. The negative electrode is what is obtained by coating a negative electrode slurry containing a negative electrode active material on a negative electrode current collector, and the positive electrode is what is obtained by coating a positive electrode slurry containing a positive electrode active material on a positive electrode current collector.

The electrode according to the present invention may be formed of a conductive member made of a metal having good conductivity. Such a conductive member is not particularly limited as long as it has high conductivity without causing a chemical change in the secondary battery. In the case that the electrode is a positive electrode, stainless steel, aluminum, nickel, titanium, plastic carbon, or what is obtained by surface-treating aluminum or stainless steel with carbon, nickel, titanium, silver or the like may be used the positive electrode current collector. The current collector may have fine irregularities on the surface thereof to increase the adhesion of the positive electrode active material, and various forms such as a film, a sheet, a foil, a net, a porous body, a foam, and a nonwoven fabric are possible. The positive electrode current collector generally has a thickness of 3 to 500 micrometers.

In the case of a negative electrode current collector, copper, stainless steel, aluminum, nickel, titanium, plastic carbon, what is obtained by surface-treating cooper or stainless steel with carbon, nickel, titanium, silver or the like, or an aluminum-cadmium alloy may be used the negative electrode current collector. The negative electrode current collector generally has a thickness of 3 to 500 micrometers.

Further, the electrode active material layer may include an electrode active material, a conductive material, and a binder. The electrode active material may be a positive electrode active material and a negative electrode active material. The positive electrode active material may be a lithium-containing oxide, and may be the same or different. A lithium-containing transition metal oxide may be used as the lithium-containing oxide.

For example, the lithium-containing transition metal oxide may be any one or a mixture of two or more selected from the group consisting of LiₓCoO₂(0.5<x<1.3), LiₓNiO₂(0.5<x<1.3), LiₓMnO₂(0.5<x<1.3), LiₓMn₂O₄(0.5<x<1.3), Liₓ(NiₐCobMn_{c})O₂(0.5<x<1.3, 0<a<1, 0<b<1, 0<c<1, a+b+c=1), LiₓNi_{1-y}Co_{y}O₂(0.5<x<1.3, 0<y<1), LiₓCo_{1-y}Mn_{y}O₂(0.5<x<1.3, 0≤y<1), LiₓNi_{1-y}Mn_{y}O₂(0.5<x<1.3, O≤y<1), Liₓ(NiₐCo_{b}Mn_{c})O₄(0.5<x<1.3, 0<a<2, 0<b<2, 0<c<2, a+b+c=2), LiₓMn_{2-z}Ni_{z}O₄(o·5<x<1·3, 0<z<2), LiₓMn_{2-z}Co_{z}O₄(0.5<x<1.3, 0<z<2), LiₓCoPO₄(0.5<x<1.3) and LiₓFePO₄(0.5<x<1.3). In addition, the lithium-containing transition metal oxide may be coated with a metal such as aluminum (Al) or a metal oxide. Further, in addition to the lithium-containing transition metal oxide, one or more of sulfide, selenide, and halide may be used.

The negative electrode active material may include a carbon material, lithium metal, silicon or tin. When a carbon material is used as the negative electrode active material, both low crystalline carbon and high crystalline carbon may be used. Representative examples of low crystalline carbon typically include soft carbon and hard carbon. Representative examples of high crystalline carbon include natural graphite, Kish graphite, pyrolytic carbon, mesophase pitch based carbon fiber, mesocarbon microbeads, mesophase pitches, and high-temperature calcined carbons such as petroleum or coal tar pitch derived cokes.

Further, the negative electrode slurry and the positive electrode slurry may further include a conductive material and a binder.

The conductive material is usually added in an amount of 1 to 30% by weight based on the total weight of the mixture including the positive electrode active material. Such a conductive material is not particularly limited as long as it has electrical conductivity without causing a chemical change in the battery, and examples thereof include graphite such as natural graphite and artificial graphite; carbon black such as carbon black, acetylene black, Ketjen black, channel black, furnace black, lamp black, and summer black; conductive fibers such as carbon fiber and metal fiber; metal powders such as carbon fluoride, aluminum and nickel powder; conductive whiskey such as zinc oxide and potassium titanate; conductive metal oxides such as titanium oxide; and conductive materials such as polyphenylene derivatives and the like.

The binder is added in an amount of 1 to 30% by weight, on the basis of the total weight of the mixture containing the positive electrode active material, as a component that assists in bonding between the active material and the conductive material and bonding to the current collector.

A non-aqueous polymer, which is soluble for an organic solvent and is not soluble for water, or a water-soluble polymer, which is not soluble for an organic solvent and is soluble for water, may be used as the binder. The non-aqueous polymer may be one or more selected from the group consisting of polyvinylidenefluoride (PVDF), polyvinylidene chloride (PVDC), polyacrylonitrile (PAN), polypropylene oxide (PPO), polyethylene oxide-propylene oxide copolymer (PEO-PPO), polytetrafluoroethylene (PTFE), polyimide (PI), polyetherimide (PEI), styrene butadiene rubber (SBR), polyacrylate and their derivatives.

The water-soluble polymer may be one or more selected from the group consisting of various cellulose derivatives such as carboxymethylcellulose (CMC), methylcellulose (MC), acetic acid phthalic acid cellulose (CAP), hydroxypropylmethylcellulose (HPMC), and hydroxypropylmethylcellulosephthalate (HPMCP).

The battery case is not particularly limited as long as it is used as an exterior material for packaging the battery, and a cylindrical, square, or pouch type may be used and specifically a pouch-type battery case may be used.

When an electrode assembly is accommodated in a battery case, an electrolyte solution may be injected into the battery case and be sealed to thereby manufacture a battery cell. At this time, it is possible to activate the battery cell through the activation process.

Likewise, the battery cell having gone through the activation process may go through a process of being charged to a specific level of SOC before being degenerated. This is to intercalate certain level of lithium ions in the negative electrode of the battery cell, and to make the conditions of the battery cell before the charge/discharge step same.

There was no limitation to the initial SOC before degeneration. However, for example, it may be the SOC at the time of a general shipping charge and specifically be in the range of 20 to 50%, and more specifically in the range of 30 to 50%.

The battery cell, which has gone through the activation process after being manufactured, is manufactured as a degenerate cell by precipitating lithium through charge/discharge. Specifically, the battery cell is charged and discharged under predetermined temperature, pressure and charge/discharge pattern conditions. At this time, it is preferable that the battery cell is charged in a harsh condition to quickly precipitate lithium in the battery cell.

Specifically, with respect to the temperature condition, the charge/discharge may be carried out at a temperature in the range of -10 to 0°C. In detail, the charge/discharge may be carried out at a temperature of -5 to 0°C. Lithium precipitation in the negative electrode may be easy when the charge/discharge is carried out in the above range. If the charge/discharge is performed at a temperature above zero, lithium precipitation may be slowly performed due to a high temperature, and if the charge/discharge is performed at a temperature below -10°C, lithium may be precipitated even in an undesired portion due to harsh conditions.

Further, with respect to the pressure condition, the charge/discharge is carried out at a pressure of 11,77 to 19,61 MPa [120 to 200 kgf/cm²]. Specifically, the charge/discharge may be carried out at a pressure of 11,77 to 17,65 MPa [120 to 180 kgf/cm²], and more specifically, it may be carried out at a pressure of 11,77 to 15,69 MPa [120 to 160 kgf/cm²]. At this time, the pressure is applied is to precipitate lithium only in portions where pressure is not applied. Lithium precipitation in the negative electrode may be easy when the charge/discharge is carried out in the above range. If the pressure applied at the time of charge/discharge is less than the above range, it is difficult for lithium precipitation to be performed in desired portions due to a low pressure, and if the pressure is above the range, the battery cell may be broken due to an excessive pressure.

Further, in the method for manufacturing a degenerate cell according to present invention, the pressure may be applied to the front surface of the battery cell or only a part of the battery cell. Pressure is not applied to a lithium-precipitation-desired portion.

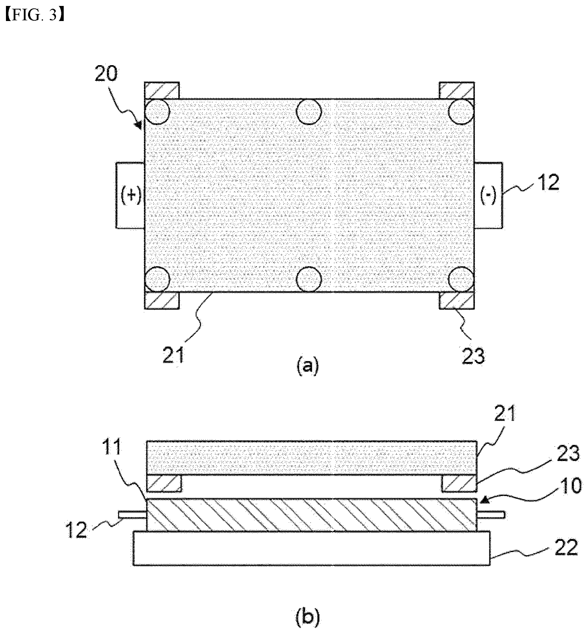

FIG. 3 is a schematic diagram illustrating a shape of a jig for pressing a battery cell in a degenerate cell manufacturing method according to an embodiment of the present invention.

Referring to FIG. 3, FIG. 3(a) is a top view of a case in which a battery cell 10 is mounted on a jig 20, and FIG. 3(b) is a side view of a case in which a battery cell 10 is mounted on a jig 20. In FIG. 3, the jig 20 for pressing the battery cell 10 is composed of a lower plate 22 where the battery cell 10 is seated, and an upper plate 21 for pressing the battery cell 10 from the upper portion. The battery cell 10 is a pouch-type battery cell, and an electrode lead 12 is drawn out from both ends of a battery case 11.

Referring to FIG. 3, the pressure may be applied to an edge portion of the battery cell from which the electrode lead 12 has been drawn out. As such, lithium precipitation may be adjusted to be performed at the central portion of the negative electrode. Further, when applying pressure to the battery cell, a damage to the battery cell can be prevented, and in order to apply uniform pressure to the pressing surface, a silicon pad 23 having elastic force may be installed on the lower surface of the upper plate 21.

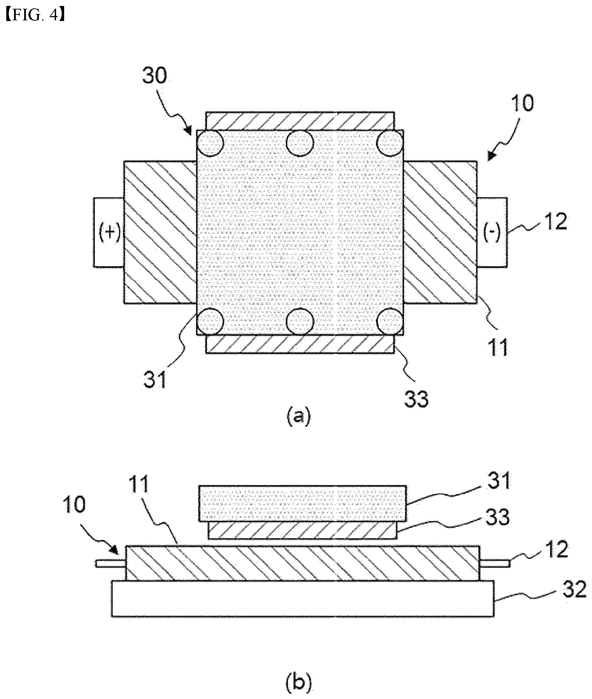

FIG. 4 is a schematic diagram illustrating a shape of a jig for pressing a battery cell in a degenerate cell manufacturing method according to another embodiment of the present invention.

Referring to FIG. 4, FIG. 4(a) is a top view of a case in which a battery cell 10 is mounted on a jig 30, and FIG. 4(b) is a side view of a case in which a battery cell 10 is mounted on a jig 30. In FIG. 4, the jig 30 for pressing the battery cell 10 is composed of a lower plate 32 where the battery cell 10 is seated, and an upper plate 31 for pressing the battery cell 10 from the upper portion. The battery cell 10 is a pouch-type battery cell, and an electrode lead 12 is drawn out from both ends of a battery case 11.

Referring to FIG. 4, the pressure may be applied to the central portion of the battery cell 10. As such, lithium precipitation may be adjusted to be performed at the edge portion of the negative electrode. Further, when applying pressure to the battery cell 10, a damage to the battery cell can be prevented, and in order to apply uniform pressure to the pressing surface, a silicon pad 33 having elastic force may be installed on the lower surface of the upper plate 31.

Further, in FIGS. 3 and 4, the jig may further include a pressing member (not shown) which transmits pressing force for lowering the upper plate in order to press the battery cell by lowering the upper plate. Such a pressing member may have a screw shape, and when the screw-shaped pressing member is rotated by a torque wrench, etc., the pressing member may lower the upper plate as the pressing member descends. At this time, the pressure applied to the battery cell may be defined as a torque fastening pressure which is applied to the pressing member when lowering the pressing member.

Further, when charging and discharging the battery cell, the charge and discharge pattern include constant current (CC)-charging the battery cell until reaching a predetermined voltage, constant voltage (CV)-charging the battery cell having reached the predetermined voltage until reaching a predetermined cutoff current, and constant current (CC)-discharging the CV-charged battery cell.

When the battery cell is CC-charged, as the current becomes close to the end voltage, the current gradually decreases, and when the current reaches the predetermined end voltage, the charging stops, and the secondary battery is then CV-charged. The charging end voltage may be, for example, 3 to 4.2V. The process of CV-charging the battery cell may be a process of charging the battery cell with the end voltage until reaching a predetermined cutoff current value. When the CV charge is performed, the current value gradually decreases while maintaining the voltage. At this time, a current value, at which the charging stops, is called a cutoff current. Likewise, by performing CV-charging after performing CC-charging, more lithium ions can be intercalated into the negative electrode, which influences lithium precipitation.

Further, the CC-charging and CC-discharging process is a processing performing charge/discharge by applying a constant current having a predetermined C-rate to the battery cell. At this time, the charge and discharge speed can be fastened for lithium precipitation. Specifically, the CC-charging and the CC-discharging can be performed at a C-rate of 0.5 to 1.5C, specifically a C-rate of 1 to 1.5C. When the charge/discharge speed is less than the above range, it may be difficult for lithium to be precipitated in the negative electrode within a short period of time, and when the charge/discharge speed exceeds the above range, lithium may be precipitated in undesired portions due to an excessively fast speed.

Further, in the degenerate cell manufacturing method according to the present invention, lithium metal in the negative electrode may be stably precipitated by 2 or more times of repetition of the charge/discharge pattern.

Further, the present invention provides a method for evaluating a degenerate cell including the above-described method for manufacturing a degenerate cell.

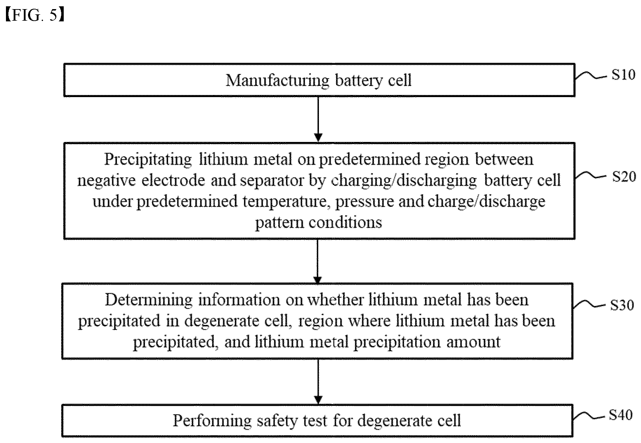

FIG. 5 is a flowchart showing the procedure of a degenerate cell evaluation method according to an embodiment of the present invention.

Referring to FIG. 5, the method for evaluating a degenerate cell includes: manufacturing a degenerate cell according to the above-described method for manufacturing a degenerate cell; and determining: whether lithium metal has been precipitated in the degenerate cell; a precipitated region of the lithium metal; and a precipitation amount of the lithium metal. As such, a method for evaluating a degenerate cell according to the present invention includes: preparing a battery cell which has a structure where an electrode assembly, which is generated by lamination of a negative electrode, a positive electrode, and a separator, is accommodated in a battery case, and an electrode lead is drawn out to an outside of the battery case (S10); precipitating lithium metal on a predetermined region between the negative electrode and the separator by performing charge and discharge under predetermined temperature, pressure and charge and discharge pattern conditions (S20); and determining: whether lithium metal has been precipitated in the degenerate cell; a precipitated region of the lithium metal; and a precipitation amount of the lithium metal (S30).

According to the degenerate cell evaluation method of the present invention, lithium precipitation according to charge/discharge conditions can be patterned, and accordingly, lithium metal may be precipitated on a desired portion of the negative electrode, to thereby evaluate the behavior of the degenerate cell. As such, it is possible to manufacture a safety-enhanced cell through a short circuit evaluation, etc. for a specific region of a negative electrode.

The determining of: whether lithium metal has been precipitated in the degenerate cell; the precipitated region of the lithium metal; and the precipitation amount of the lithium metal includes manufacturing a degenerate cell while changing the temperature, pressure and charge/discharge pattern conditions, and building a database using information on whether lithium metal has been precipitated in the degenerate cell, the precipitated region of the lithium metal, and the precipitation amount of the lithium metal according to the temperature, pressure, and charge and discharge pattern. At this time, the lithium metal precipitation amount, for example, may be obtained by measuring the amount of change of the weight of the electrode or the battery cell before and after the charge/discharge.

In this case, it is possible to obtain data on the lithium precipitation pattern, such as information on whether lithium metal has been precipitated in the degenerate cell, the region where lithium metal has been precipitated, and the lithium metal precipitation amount while changing at least one of three variables which are the temperature, pressure and charge/discharge pattern, and it is possible to derive the correlation between the charge/discharge condition and the lithium precipitation pattern from the data. Specifically, after recognizing information on the lithium precipitation pattern according to the charge/discharge condition, the information may be accumulated in a storage system such as a memory, and such data may be recorded as visual data such as tables or graphs.

Further, according to a degenerate cell evaluation method of the present invention, it is possible to derive correlation with a lithium precipitation pattern according to the SOC of a degenerate cell under the same charge/discharge conditions by adjusting the SOC of the degenerate cell, and building a database about the temperature, pressure, charge/discharge pattern condition, information on where lithium metal has been precipitated according to the SOC of the degenerate cell, the region where lithium metal has been precipitated, and the lithium metal precipitation amount. The details about building a database are the same as those described above.

Further, referring to FIG. 5, the method for evaluating a degenerate cell according to an embodiment of the present invention may further include performing a safety test for the degenerate cell (S40). An example of the safety test is an external short circuit test, which includes a nail test of allowing a nail-shaped conductor to penetrate a degenerate cell, or a drop test of determining whether there has been a short circuit which occurs by an impact at a drop by dropping a battery cell. Specifically, a portion, which is vulnerable to a short circuit, may be recognized by performing an external short circuit test for the lithium precipitation pattern. It is also possible to evaluate safety by simulating the modes of various degenerate cells.

At this time, the safety test may be performed after the degenerate cell is charged to show a predetermined state of charge (SOC). In other words, the safety test can be performed while changing the SOC of the degenerate cell. It is possible to verify the safety risk and the short circuit risk site for each SOC of the degenerate cell through the safety test according to charge/discharge conditions and SOC of the degenerate cell. Likewise, the degenerate cell evaluation method according to the present invention may be utilized as the basis for manufacturing safety-improved cells through a short circuit evaluation, etc.

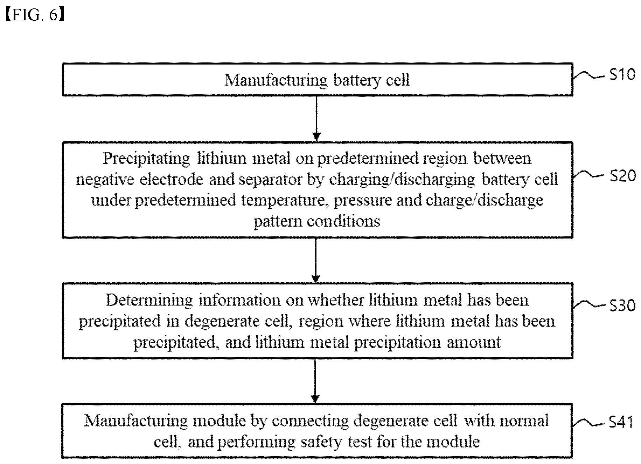

FIG. 6 is a flowchart showing the procedure of a degenerate cell evaluation method according to another embodiment of the present invention.

Referring to FIG. 6, the method for evaluating the degenerate cell according to another embodiment of the present invention further includes preparing a module by connecting the degenerate cells and normal cells, where degeneration has not occurred, in series or in parallel, and performing an external short circuit test for the module. Namely, the method for evaluating a degenerate cell includes: preparing a battery cell which has a structure where an electrode assembly, which is generated by lamination of a negative electrode, a positive electrode, and a separator, is accommodated in a battery case, and an electrode lead is drawn out to an outside of the battery case (S10); precipitating lithium metal on a predetermined region between the negative electrode and the separator by performing charge and discharge under predetermined temperature, pressure and charge and discharge pattern conditions (S20); and determining: whether lithium metal has been precipitated in the degenerate cell; a precipitated region of the lithium metal; a precipitation amount of the lithium metal (S30); and preparing a module by connecting the degenerate cell with a normal cell and performing a safety test for the module (S40).

Specifically, after assembling degenerate cells and normal cells where degeneration has not occurred in module or pack units, a performance and short circuit test for this can be performed. At this time the test can be performed while changing the numbers of degenerate cells and normal cells where degeneration has not occurred. It is also possible to evaluate safety by simulating the modes of various degenerate cells.

At this time, the safety test may be performed after the degenerate cell is charged to show a predetermined state of charge (SOC). In other words, the safety test can be performed while changing the SOC of the degenerate cell.

According to the method of evaluating a degenerate cell of the present invention, it is possible to evaluate the influence of the degenerate cell on a battery module or pack by simulating the battery module or pack degenerated by the actual use by connecting a plurality of degenerate cells and normal cells, where degeneration has not occurred, in series or in parallel. Further, it is possible to verify the safety risk and the short circuit risk site for each SOC of the degenerate cell in a state that is assembled as a module or a pack through an external short circuit test according to the SOC of the degenerate cell.

Hereinafter, the present invention will be described in detail with reference to examples. However, the embodiments according to the present invention may be modified into various other forms, and the scope of the present invention should not be construed as being limited to the examples described below. The examples of the present invention are provided to more fully describe the present invention to those skilled in the art.

### Preparation example

A positive electrode mixture was prepared by mixing 96.7 parts by weight of Li[Ni_{0.6}Mn_{0.2}Co_{0.2}]O₂ serving as a positive electrode active material, 1.3 parts by weight of graphite serving as a conductive material, and 2.0 parts by weight of polyvinylidene fluoride (PVdF) serving as a binder. The positive electrode slurry was prepared by dispersing the obtained positive electrode mixture in 1-methyl-2-pyrrolidone functioning as a solvent. A positive electrode was prepared by coating, drying, and pressing the slurry on both sides of an aluminum foil having a thickness of 20 µm, respectively.

A negative electrode mixture was prepared by mixing 97.6 parts by weight of artificial graphite and natural graphite that function as negative electrode active materials (weight ratio: 90 : 10), 1.2 parts by weight of styrene-butadiene rubber (SBR) that functions as a binder, and 1.2 parts by weight of carboxymethyl cellulose (CMC). The negative electrode slurry was prepared by dispersing the negative electrode mixture in ion-exchanged water functioning as a solvent. A negative electrode was prepared by coating, drying, and pressing the slurry on both sides of an copper foil having a thickness of 20 µm.

A non-aqueous electrolyte solution was prepared by dissolving LiPF₆ in an organic solvent, in which ethylene carbonate (EC), propylene carbonate (PC), and diethyl carbonate (DEC) were mixed in a composition of 3 : 3 : 4 (volume ratio). Herein, LiPF₆ was dissolved in the organic solvent to be a concentration of 1.0M.

A battery cell was prepared by laminating a porous polyethylene separator between the positive electrode and the negative electrode prepared above and storing them in a pouch, and then injecting the electrolyte solution.

### Example

The battery cell prepared in the above preparation example was activated to adjust the SOC to become 30%. The battery cell was charged under a specific temperature, pressure and charge/discharge pattern in a state that the central portion of the battery cell was pressed using a pressing jig illustrated in FIG. 4.

Specifically, the temperature at the charge/discharge was -5°C, and the pressure was 11,77 MPa [120 kgf/cm²]. At this time, the pressure is the torque fastening pressure received by a pressing member included in the pressing jig according to FIG. 4.

Further, when the charge/discharge was performed, the battery cell was charged at the C-rate of 1C until the voltage reached 4.2V. When the voltage reached 4.2V, the charge was continued until the current value of the battery cell reached 0.95C while maintaining the voltage. When the current value of the battery cell reached the cutoff current value, the battery cell was discharged at the C-rate of 1C. The charge/discharge pattern as described above was performed once.

### Comparative Example 1

The battery cell prepared in the above preparation example was activated to adjust the SOC to become 30%. The battery cell was charged under a specific temperature, pressure and charge/discharge pattern in a state that the central portion of the battery cell was pressed using a pressing jig illustrated in FIG. 4.

Specifically, the temperature at the charge/discharge was -15°C, and the pressure was 11,77 MPa [120 kgf/cm²]. At this time, the pressure is the torque fastening pressure received by a pressing member included in the pressing jig according to FIG. 4.

Further, when the charge/discharge was performed, the battery cell was charged at the C-rate of 1C until the voltage reached 4.2V. When the voltage reached 4.2V, the charge was continued until the current value of the battery cell reached 0.05C while maintaining the voltage. When the current value of the battery cell reached the cutoff current value, the battery cell was discharged at the C-rate of 1C. The charge/discharge pattern as described above was performed once.

### Comparative Example 2

The battery cell prepared in the above preparation example was activated to adjust the SOC to become 30%. The battery cell was charged under a specific temperature, pressure and charge/discharge pattern in a state that the central portion of the battery cell was pressed using a pressing jig illustrated in FIG. 4.

Specifically, the temperature at the charge/discharge was -15°C, and the pressure was 11,77 MPa [120 kgf/cm²]. At this time, the pressure is the torque fastening pressure received by a pressing member included in the pressing jig according to FIG. 4.

Further, the battery cell was constant power (CP)-charged while maintaining the output of 1W and reducing the current until the voltage of the battery cell reached 4.2V at the time of charge/discharge. Thereafter, when the voltage of the battery cell reached 4.2V, the battery cell was CP-discharged while maintaining the output of 1W. The charge/discharge pattern as described above was performed 4 times.

### Comparative Example 3

The battery cell prepared in the above preparation example was activated to adjust the SOC to become 30%. The battery cell was charged under a specific temperature, pressure and charge/discharge pattern in a state that the central portion of the battery cell was pressed using a pressing jig illustrated in FIG. 4.

Specifically, the temperature at the charge/discharge was 25°C (room temperature), and the pressure was 11,77 MPa [120 kgf/cm²]. At this time, the pressure is the torque fastening pressure received by a pressing member included in the pressing jig according to FIG. 4.

Further, the battery cell was constant power (CP)-charged while maintaining the output of 1W and reducing the current until the voltage of the battery cell reached 4.2V at the time of charge/discharge. Thereafter, when the voltage of the battery cell reached 4.2V, the battery cell was CP-discharged while maintaining the output of 1W. The charge/discharge pattern as described above was performed 4 times.

### Experimental Example

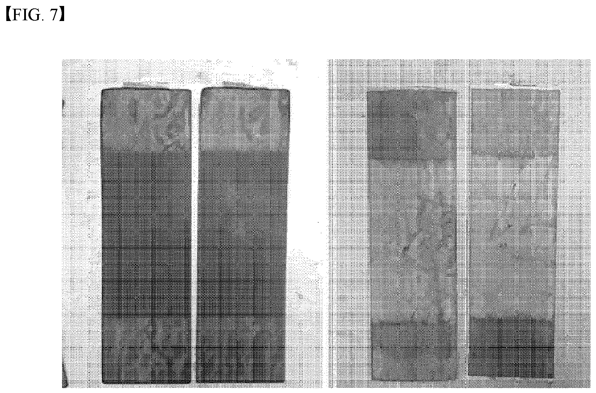

After disassembling the charge/discharge-completed battery cell, it was checked whether lithium has been precipitated in the negative electrode. The result was shown in FIGS. 7 to 10.

Referring to FIG. 7, it was confirmed that lithium was precipitated on the region (battery cell edge portion) which has not been pressed in the case that the battery cell was charged and discharged according to the example. Namely, in the degenerate cell manufacturing method according to the present invention, lithium may be precipitated on a desired portion by pressing a specific portion of the battery cell under specific charge/discharge conditions.

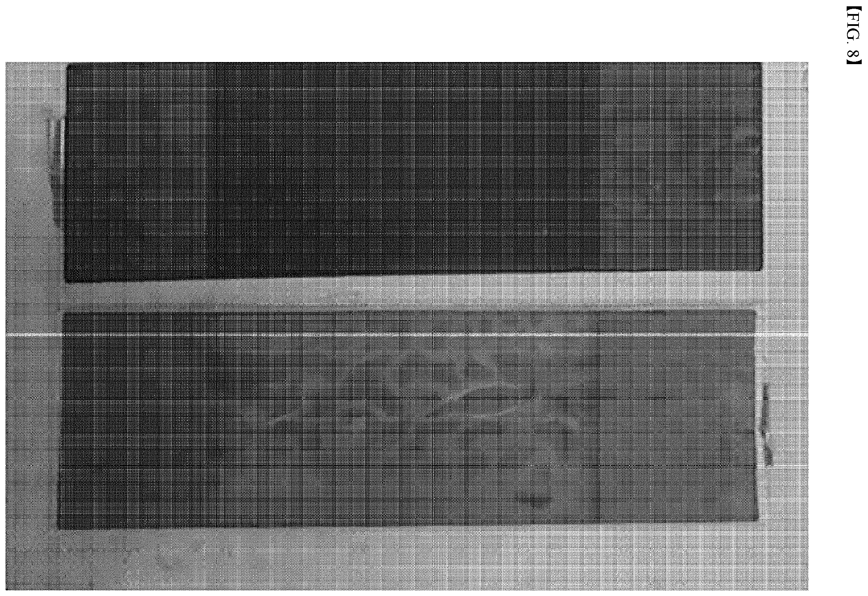

However, referring to FIG. 8, in the case of the comparative example where the temperature at the time of charge/discharge was adjusted to -15°C, lithium was precipitated even on the central portion which has been pressed, and thus lithium metal was precipitated even on an undesired portion.

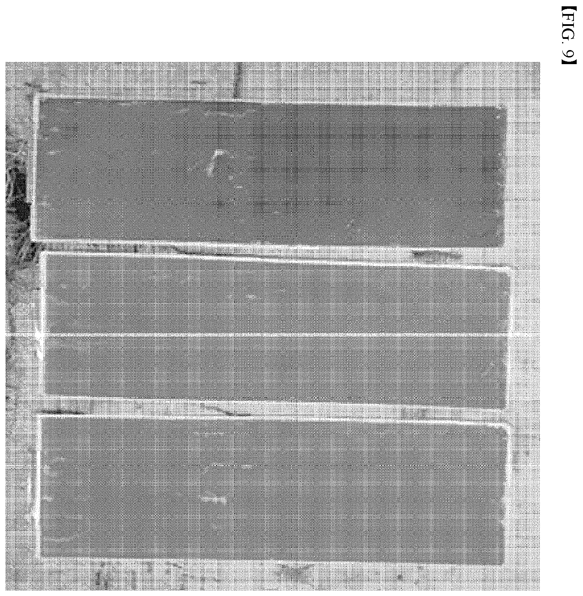

Further, in the case of the comparative example 2 where the temperature at the time of charge/discharge was adjusted to -15°C, and the battery cell was CP-charged and CP-discharged, lithium metal was precipitated on the front surface of the negative electrode, and thus lithium metal was precipitated even on an undesired portion as shown in FIG. 9.

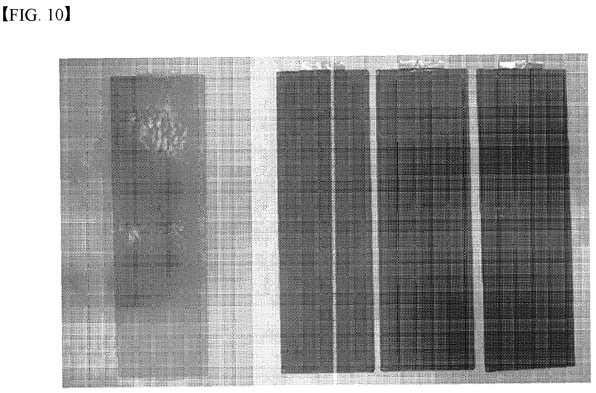

Further, in the case of the comparative example 2 where a battery cell was charged and discharged in a room temperature, it was confirmed that lithium metal was not precipitated despite the fact that CP-charging and CP-discharging were performed 4 times as in FIG. 10.

Namely, according to a degenerate cell manufacturing method and a degenerate cell evaluation method including the same of the present invention, it is possible to precipitate lithium metal on desired portions by performing charge/discharge under predetermined conditions.

## Claims

1. A method for manufacturing a degenerate cell, the method comprising:
preparing a battery cell which has a structure where an electrode assembly, which is generated by lamination of a negative electrode, a positive electrode, and a separator, is accommodated in a battery case, and an electrode lead is drawn out to an outside of the battery case; and
precipitating lithium metal on a predetermined region between the negative electrode and the separator by performing charge and discharge under predetermined temperature, pressure and charge and discharge pattern conditions,
wherein the charge and discharge is performed under a pressure in a range of 11,77 to 19,61 MPa,
wherein the charge and discharge pattern includes constant current (CC)-charging the battery cell until reaching a predetermined voltage, constant voltage (CV)-charging the battery cell having reached the predetermined voltage until reaching a predetermined cutoff current, and constant current (CC)-discharging the CV-charged battery cell, and
wherein the pressure is not applied to a lithium-precipitation-desired portion.

2. The method of claim 1, wherein an initial state of charge (SOC) of the battery cell corresponds to 20 to 50%.

3. The method of claim 1, wherein the charge and discharge is performed under a temperature in a range of -10 to 0°C.

4. The method of claim 1, wherein the CC-charging and the CC-discharging are performed at a C-rate in a range of 0.5 to 1.5C.

5. The method of claim 1, wherein a charge and discharge according to the charge and discharge pattern is performed two or more times.

6. A method for evaluating a degenerate cell, the method comprising:
manufacturing a degenerate cell, wherein manufacturing comprises
preparing a battery cell which has a structure where an electrode assembly, which is generated by lamination of a negative electrode, a positive electrode, and a separator, is accommodated in a battery case, and an electrode lead is drawn out to an outside of the battery case; and wherein manufacturing further comprises
precipitating lithium metal on a predetermined region between the negative electrode and the separator by performing charge and discharge under predetermined temperature, pressure and charge and discharge pattern conditions,
wherein the charge and discharge is performed under a pressure in a range of 11,77 to 19,61 MPa,
wherein the charge and discharge pattern includes constant current (CC)-charging the battery cell until reaching a predetermined voltage, constant voltage (CV)-charging the battery cell having reached the predetermined voltage until reaching a predetermined cutoff current, and constant current (CC)-discharging the CV-charged battery cell, and
wherein the pressure is not applied to a lithium-precipitation-desired portion; and
wherein the method for evaluating a degenerate cell further comprises determining: whether lithium metal has been precipitated in the degenerate cell; a precipitated region of the lithium metal; and a precipitation amount of the lithium metal.

7. The method of claim 6, wherein the determining of: whether lithium metal has been precipitated in the degenerate cell; the precipitated region of the lithium metal; and the precipitation amount of the lithium metal includes building a database using information on whether lithium metal has been precipitated in the degenerate cell, the precipitated region of the lithium metal, and the precipitation amount of the lithium metal according to the temperature, pressure, and charge and discharge pattern.

8. The method of claim 6, further comprising performing a safety test for the degenerate cell.

9. The method of claim 8, wherein the safety test is performed after the degenerate cell is charged to show a predetermined state of charge (SOC).

10. The method of claim 6, further comprising: preparing a module by connecting the degenerate cells and normal cells, where degeneration has not occurred, in series or in parallel, and performing a safety test for the module.

11. The method of claim 10, wherein the safety test is performed after the degenerate cell is charged to show a predetermined state of charge (SOC).

## Patentansprüche

1. Verfahren zur Herstellung einer degenerierten Zelle, wobei das Verfahren umfasst:
Herstellen einer Batteriezelle mit einer Struktur, bei der eine Elektrodenanordnung, die durch Laminieren einer negativen Elektrode, einer positiven Elektrode und eines Separators erzeugt wird, in einem Batteriegehäuse untergebracht wird, wobei ein Elektrodenanschluss aus dem Batteriegehäuse herausgeführt wird; und
Ausfällen von Lithiummetall auf einem vorbestimmten Bereich zwischen der negativen Elektrode und dem Separator durch Durchführen eines Lade- und Entladevorgangs unter vorbestimmten Temperatur-, Druck- und Lade- und Entlademusterbedingungen,
wobei das Laden und Entladen unter einem Druck im Bereich von 11,77 bis 19,61 MPa durchgeführt wird,
wobei das Lade- und Entlademuster das Laden der Batteriezelle mit konstantem Strom (CC) bis zum Erreichen einer vorbestimmten Spannung, das Laden der Batteriezelle mit konstanter Spannung (CV) nach Erreichen der vorbestimmten Spannung bis zum Erreichen eines vorbestimmten Abschaltstroms, und das Entladen der CV-geladenen Batteriezelle mit konstantem Strom (CC) umfasst, und
wobei der Druck nicht auf einen Bereich ausgeübt wird, in dem eine Lithiumausfällung erwünscht ist.

2. Verfahren nach Anspruch 1, wobei ein anfänglicher Ladezustand (SOC) der Batteriezelle 20 bis 50 % beträgt.

3. Verfahren nach Anspruch 1, wobei das Laden und Entladen bei einer Temperatur im Bereich von -10 bis 0 °C durchgeführt wird.

4. Verfahren nach Anspruch 1, wobei das CC-Laden und das CC-Entladen mit einer C-Rate im Bereich von 0,5 bis 1,5 C durchgeführt werden.

5. Verfahren nach Anspruch 1, wobei ein Laden und Entladen gemäß dem Lade- und Entlademuster zwei- oder mehrmals durchgeführt wird.

6. Verfahren zur Bewertung einer degenerierten Zelle, wobei das Verfahren umfasst:
Herstellung einer degenerierten Zelle, wobei die Herstellung umfasst
das Herstellen einer Batteriezelle, die eine Struktur aufweist, bei der eine Elektrodenanordnung, die durch Laminieren einer negativen Elektrode, einer positiven Elektrode und eines Separators erzeugt wird, in einem Batteriegehäuse untergebracht wird und ein Elektrodenanschluss aus dem Batteriegehäuse herausgeführt wird; und wobei die Herstellung ferner umfasst
das Ausfällen von Lithiummetall auf einem vorbestimmten Bereich zwischen der negativen Elektrode und dem Separator durch Durchführen von Lade- und Entladevorgängen unter vorbestimmten Temperatur-, Druck- und Lade- und Entlademusterbedingungen,
wobei das Laden und Entladen unter einem Druck im Bereich von 11,77 bis 19,61 MPa durchgeführt wird,
wobei das Lade- und Entlademuster das Laden der Batteriezelle mit konstantem Strom (CC) bis zum Erreichen einer vorbestimmten Spannung, das Laden der Batteriezelle mit konstanter Spannung (CV) nach Erreichen der vorbestimmten Spannung bis zum Erreichen eines vorbestimmten Abschaltstroms und das Entladen der CV-geladenen Batteriezelle mit konstantem Strom (CC) umfasst, und
wobei der Druck nicht auf einen Bereich ausgeübt wird, in dem eine Lithiumausfällung erwünscht ist; und
wobei das Verfahren zur Bewertung einer degenerierten Zelle ferner umfasst das bestimmt wird: ob Lithiummetall in der degenerierten Zelle ausgefällt wurde; ein Ausfällungsbereich des Lithiummetalls; und eine Ausfällungsmenge des Lithiummetalls.

7. Verfahren nach Anspruch 6, wobei das Bestimmen, ob Lithiummetall in der degenerierten Zelle ausgefällt wurde, den Ausfällungsbereich des Lithiummetalls und der Ausfällungsmenge des Lithiummetalls das Erstellen einer Datenbank unter Verwendung von Informationen darüber umfasst, ob Lithiummetall in der degenerierten Zelle ausgefällt wurde, des Ausgefällbereichs des Lithiummetalls und der Ausfällungsmenge des Lithiummetalls in Abhängigkeit von Temperatur, Druck sowie Lade- und Entlademuster.

8. Verfahren nach Anspruch 6, das ferner die Durchführung eines Sicherheitstests für die entladene Zelle umfasst.

9. Verfahren nach Anspruch 8, wobei der Sicherheitstest durchgeführt wird, nachdem die entladene Zelle derart geladen wurde, dass sie einen vorbestimmten Ladezustand (SOC) aufweist.

10. Verfahren nach Anspruch 6, das ferner umfasst: Herstellen eines Moduls durch Reihenschaltung oder Parallelschaltung der degenerierten Zellen und normaler Zellen, bei denen keine Degeneration aufgetreten ist, sowie Durchführen einer Sicherheitsprüfung für das Modul.

11. Verfahren nach Anspruch 10, wobei der Sicherheitstest durchgeführt wird, nachdem die degenerierte Zelle derart geladen wurde, dass sie einen vorbestimmten Ladezustand (SOC) aufweist.

## Revendications

1. Procédé de fabrication d'une cellule dégradée, le procédé comprenant :
la préparation d'une cellule de batterie possédant une structure dans laquelle un ensemble d'électrode, généré par la stratification d'une électrode négative, d'une électrode positive, et d'un séparateur, est installé dans un boîtier de batterie, et un câble d'électrode est extrait vers un extérieur du boîtier de batterie ; et
la précipitation de lithium métallique sur une zone prédéterminée entre l'électrode négative et le séparateur en effectuant une charge et une décharge dans des conditions de température, pression, et configuration de charge et décharge prédéterminées,
la charge et la décharge étant effectuées sous une pression comprise dans une plage allant de 11,77 à 19,61 MPa,
la configuration de charge et décharge comprenant une charge à courant continu (CC) de la cellule de batterie jusqu'à ce qu'elle atteigne une tension prédéterminée, une charge à tension constante (CV) de la cellule de batterie, qui a atteint la tension prédéterminée, jusqu'à ce qu'elle atteigne un courant de coupure prédéterminé, et une décharge à courant continu (CC) de la cellule de batterie chargée à CV, et
la pression n'étant pas appliquée sur une partie à précipitation de lithium désirée.

2. Procédé selon la revendication 1, un état de charge (SOC) initial de la cellule de batterie correspondant à 20 à 50%.

3. Procédé selon la revendication 1, la charge et la décharge étant effectuées avec une température dans une plage allant de -10 à 0°C.

4. Procédé selon la revendication 1, la charge à CC et la décharge à CC étant effectuées avec un débit C dans une plage allant de 0,5 à 1,5C.

5. Procédé selon la revendication 1, une charge et une décharge conformes à la configuration de charge et décharge étant effectuées deux ou plusieurs fois.

6. Procédé d'évaluation d'une cellule dégradée, le procédé comprenant :
la fabrication d'une cellule dégradée, la fabrication comprenant :
la préparation d'une cellule de batterie possédant une structure dans laquelle un ensemble d'électrode, généré par la stratification d'une électrode négative, d'une électrode positive, et d'un séparateur, est installé dans un boîtier de batterie, et un câble d'électrode est extrait vers un extérieur du boîtier de batterie ; et
la fabrication comportant en outre une précipitation de lithium métallique sur une zone prédéterminée entre l'électrode négative et le séparateur, en effectuant une charge et une décharge dans des conditions de température, pression, et charge et décharge prédéterminées,
la charge et la décharge étant effectuées sous une pression dans une plage allant de 11,77 à 19,61 MPa,
la configuration de charge et décharge comprenant une charge à courant continu (CC) de la cellule de batterie jusqu'à ce qu'elle atteigne une tension prédéterminée, une charge à tension constante (CV) de la cellule de batterie, qui a atteint la tension prédéterminée, jusqu'à ce qu'elle atteigne un courant de coupure prédéterminé, et une décharge à courant continu (CC) de la cellule de batterie chargée à CV, et
la pression n'étant pas appliquée sur une partie à précipitation de lithium désirée ; et
le procédé d'évaluation d'une cellule dégradée comportant en outre les déterminations suivantes : si du lithium métallique a été précipité dans la cellule dégradée ; une zone précipitée du lithium métallique ; et une quantité de précipitation de lithium métallique.

7. Procédé selon la revendication 6, dans lequel les déterminations suivantes : si du lithium métallique a été précipité dans la cellule dégradée ; la zone précipitée de lithium métallique ; et la quantité de précipitation de lithium métallique, nécessitent la constitution d'une base de données utilisant des informations pour établir s'il y a eu une précipitation de lithium métallique dans la cellule dégradée, la zone de précipitation du lithium métallique, et la quantité de précipitation de lithium métallique en fonction de la température, de la pression, et de la configuration de charge et décharge.

8. Procédé selon la revendication 6, comprenant en outre l'exécution d'un essai de sécurité pour la cellule dégradée.

9. Procédé selon la revendication 8, l'essai de sécurité étant effectué lorsque la cellule dégradée a été chargée pour indiquer un état de charge (SOC) prédéterminé.

10. Procédé selon la revendication 6, comprenant en outre : la préparation d'un module en connectant les cellules dégradées et des cellules normales, où la dégradation ne s'est pas produite, en série et en parallèle, et l'exécution d'un essai de sécurité pour le module.

11. Procédé selon la revendication 10, l'essai de sécurité étant effectué lorsque la cellule dégradée a été chargée pour indiquer un état de charge (SOC) prédéterminé.
